# EUROPEAN PATENT SPECIFICATION

(11) **EP 2 098 750 B1**
(45) Date of publication and mention of the grant of the patent: **16.05.2012**
(21) Application number: 09003049.5
(22) Date of filing: 03.03.2009
(51) Int. Cl.: F16F 15/027

(54) **Vibration suppression apparatus, exposure apparatus, and method of manufacturing device**
Schwingungsunterdrückungsvorrichtung, Belichtungsvorrichtung und Verfahren zur Herstellung der Vorrichtung
Appareil de suppression de vibration, appareil d'exposition, et procédé de fabrication du dispositif

(30) Priority: 04.03.2008 JP 2008054067
(43) Date of publication of application: 09.09.2009
(73) Proprietor: Canon Kabushiki Kaisha, Tokyo (JP)
(72) Inventor: Mayama, Takehiko, Ohta-ku Tokyo (JP); Takabayashi, Yukio, Ohta-ku Tokyo (JP)
(74) Representative: Weser, Wolfgang

(56) References cited:
- EP-A2- 0 368 607
- WO-A1-00/03582
- JP-A- 2 026 334
- JP-A- 11 141 599
- JP-A- 11 294 520
- US-A- 4 477 045
- US-A- 4 850 261
- US-A1- 2006 126 040
- US-B1- 6 170 622

## Description

### BACKGROUND OF THE INVENTION

### Field of the Invention

The present invention relates to a vibration suppression apparatus, and an exposure apparatus.

### Description of the Related Art

Along with improvements in the precision of exposure apparatuses, a demand has arisen for techniques of vibration suppression with a higher performance in order to prevent vibration which adversely affects exposure from occurring in, for example, a structure which forms the main body of the exposure apparatus and a projection lens. To achieve this, it is being demanded to insulate as much as possible the main body of the exposure apparatus from external vibration transmitted from, for example, the base on which the exposure apparatus is installed. It is also being demanded to quickly reduce vibration which occurs upon operation of a device including a driving mechanism such as a stage device mounted in the main body of the exposure apparatus.

To meet these demands, an active vibration suppression apparatus is widely applied to exposure apparatuses. The active vibration suppression apparatus detects by sensors the position and vibration of a surface plate which mounts the apparatus main body, and drives an actuator, that applies a control force to the surface plate, based on the detection results. Moreover, a technique of more effectively suppressing vibration by compensating the signal from a device including a driving mechanism such as a stage device mounted on the surface plate, and feed-forwarding the compensation signal to the actuator is applied to an apparatus of this type.

Japanese Patent Laid-Open No. 11-294520 discloses an active vibration suppression apparatus configured to reduce or suppress vibration of a surface plate using an air spring which supports the surface plate as an air pressure actuator, and, simultaneously, using an electromagnetic linear motor arranged dynamically parallel to the air spring. The active vibration suppression apparatus detects, for example, the position or acceleration of the surface plate using a sensor, and controls each actuator based on the signal obtained by compensation calculation for the detection result. In addition, the active vibration suppression apparatus more effectively controls vibration by controlling each actuator using the signal obtained by compensating the signal from a stage device mounted on the surface plate.

Assume that the vibration suppression apparatus supports the surface plate or devices vulnerable to vibration, which are mounted on the surface plate. In this case, the vibration suppression apparatus often supports the surface plate by four or more support mechanisms having a vibration suppression function, depending on the design limitations of the device arrangement and the support structure of the surface plate. Conventionally, such a vibration suppression apparatus including four or more support mechanisms having a vibration suppression function controls control signals for the position or vibration of six degrees of freedom of a rigid body using four or more actuators for each of the vertical and horizontal directions.

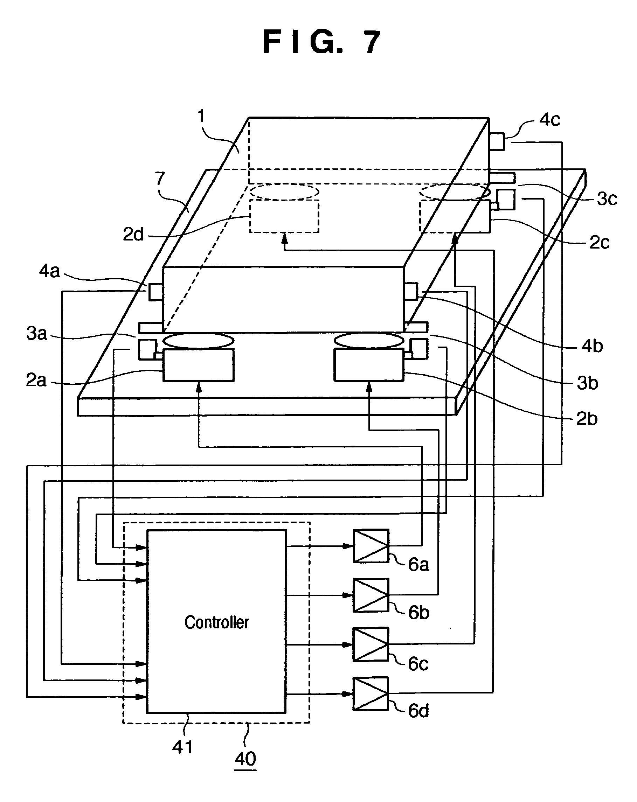

Fig. 7 shows a prior art of a vibration suppression apparatus including four support mechanisms having a vibration suppression function of supporting a surface plate 1 in the vertical direction while suppressing its vibration. The apparatus shown in Fig. 7 supports the surface plate 1 by four support mechanisms 2a to 2d having a vibration suppression function. Although not shown, each of the support mechanisms 2a to 2d having a vibration suppression function includes a spring element and damper element. If an air spring is used as the support mechanism having a vibration suppression function, a control valve which controls its internal pressure is often used as an actuator. The apparatus shown in Fig. 7 uses an air spring as the support mechanism having a vibration suppression function and as an air pressure actuator.

The vibration suppression apparatus includes position detectors 3a to 3c which detect the position of the surface plate 1 with respect to a reference position, and vibration sensors 4a to 4c which detect vibration of the surface plate 1. The detection signals from these detectors and sensors are sent to a compensation calculator 41 of a controller 40. The compensation calculator 41 performs appropriate compensation calculation for difference signals between the position detection signals and their target values, and the vibration detection signals. The signals obtained as a result of the compensation calculation are sent to driving circuits 6a to 6d to drive the actuators of the support mechanisms 2a to 2d having a vibration suppression function.

In such a vibration suppression apparatus using four or more support mechanisms 2a to 2d having a vibration suppression function, and four or more actuators, the actuators for use in control may be redundant for the degrees of freedom of rigid-body motion of the apparatus, resulting in deformation of a structure such as the surface plate. To avoid this situation, the following approaches have been proposed in order to suppress deformation of the structure.

The first approach is to detect deformation of the structure and control to suppress it, or to control each actuator with a force balance good enough to prevent deformation of the structure. This approach is disclosed in, for example, Japanese Patent Laid-Open Nos. 7-83276 and 7-139582. An apparatus of this type extracts signals corresponding to rigid-body motion modes and some deformation modes by coordinate transformation by taking account of deformation modes which can occur depending on the support balance of four support mechanisms having a vibration suppression function, and configures a control system for each mode. By taking account of the geometrical arrangement and characteristics of the actuators which apply control forces to the surface plate, the control commands for respective modes obtained as a result of control calculation are distributed to the actuators so as to act on the surface plate. As a matter of course, it is also effective to distribute thrusts to the actuators so as not to deform the structure in calculation for distributing control forces without extracting any signals representing the deformation modes.

However, depending on the above-mentioned first approach, the air pressure control system cannot sufficiently prevent deformation of the structure. In many cases, a servo valve which is widely used for the air pressure control system generally exhibits input/output characteristics with hysteresis. For this reason, when the servo valve is operated with a large range, it often cannot produce a control force according to the input signal with high precision. Because the support balance of the surface plate is excessively constrained by redundant actuators, a deviation in the control force of the actuator often fluctuates the support balance, resulting in dynamic deformation of the structure.

The second approach is to improve the control precision of action forces by configuring a control system which feeds back the control force of each actuator to the signal input to it. More specifically, a widely known approach feeds back, for example, the control force detected by a force sensor, the control pressure of an air pressure actuator, or the driving current or current value of an electromagnetic actuator.

Japanese Patent Laid-Open Nos. 10-256141 and 11-141599 and the like disclose techniques in which the second approach is applied to a control suppression apparatus. The second approach reduces a deviation between a control force commanded by the input signal and a force actually produced by the actuator, thus greatly improving the followability of the control force with respect to the input signal. Hence, appropriately distributing the signals input to the actuators makes it possible to reduce any forces which trigger deformation of the structure, thus suppressing deformation of the structure. Even when the operation range of the servo valve in the air pressure control system is relatively large, deformation of the apparatus main body is expected to be suppressed.

The third approach is to operate a plurality of support mechanisms having a vibration suppression function by the same control force. As disclosed in Japanese Patent No. 3337906, this approach is implemented by connecting two air springs or tanks which communicate with them through a pipe in a vibration suppression apparatus including, for example, four support mechanisms having a vibration suppression function. In such an apparatus, two out of four air springs have an equal internal pressure, and the four air springs have three pressure values accordingly, leading to a constant support balance which is determined by the load of the structure and its center of gravity. This approach determines one combination of forces that achieves support balance of the load. This makes it possible to prevent the deformation state of the structure from changing free from any fluctuation in the support balance of the structure.

As described above, the conventional vibration suppression apparatus suppresses deformation of the structure by various approaches even when it is inevitable that the support balance of the structure is excessively constrained by redundant actuators due to, for example, the limitations of the apparatus structure.

However, along with the recent improvements in the precision of devices mounted on the vibration suppression apparatus, it is being demanded to further suppress deformation of the structure. A fluctuation in the support balance of the vibration suppression apparatus triggers deformation of a mounted surface plate. As a consequence, the deformation adversely affects the devices mounted on the surface plate as well, which, in turn, adversely affects the measurement performance and exposure performance, which are required to improve.

Under the circumstances, suppression of deformation of the structure is becoming a more serious challenge than ever before, and therefore a fluctuation in the support balance at a conventionally negligible level is becoming problematic.

Vibration suppression is indispensable to attaining an improvement in the precision of an exposure apparatus. This makes it necessary to suppress local vibration harmful to the exposure apparatus by increasing the rigidity of a structure which forms the exposure apparatus. However, the higher the rigidity of the structure, the heavier the structure. Because of this conflict, a design which prioritizes weight reduction of the structure is often required. This may make it impossible to sufficiently ensure the rigidity of the structure. In this manner, it becomes harder to suppress deformation of the structure when four or more support mechanisms having a vibration suppression function are used under the condition in which a sufficient rigidity of the structure cannot be ensured.
Another example for such a device is shown in the US4850261.

### SUMMARY OF THE INVENTION

The present invention is directed to a vibration suppression apparatus which includes five or more actuators that apply forces to a structure and, at the same time, suppresses vibration of the structure while suppressing its deformation.

The present invention in its first aspect provides a vibration suppression apparatus as specified in claims 1 to 6.

The present invention in its second aspect provides an exposure apparatus as specified in claims 6 and 8.

According to the present invention, it is possible to provide a vibration suppression apparatus which includes, for example, five or more actuators that apply forces to a structure and, at the same time, suppresses vibration of the structure while suppressing its deformation.

Further features of the present invention will become apparent from the following description of exemplary embodiments with reference to the attached drawings. In the subsequent, the reference examples fall outside the scope of the invention as claimed, but serve for better understanding the present invention.

### BRIEF DESCRIPTION OF THE DRAWINGS

Fig. 1 is a view showing a vibration suppression apparatus according to the first reference example*.*

Fig. 2 is a view showing an actuator according to the first reference example;

Fig. 3 is a view showing a vibration suppression apparatus according to the second reference example;

Fig. 4 is a view showing an actuator according to the third reference example

Fig. 5 is a view showing a vibration suppression apparatus according to the third reference example;

Fig. 6 is a view showing a vibration suppression apparatus according to the first embodiment;

Fig. 7 is a view showing a conventional vibration apparatus; and

Fig. 8 is a view for explaining an exposure apparatus.

### DESCRIPTION OF THE EMBODIMENTS

Embodiments of a vibration suppression apparatus according to the present invention will be described below with reference to the accompanying drawings. The vibration suppression apparatus according to the present invention can be used for exposure apparatuses, electron microscopes, machine tools, and the like. However, a vibration suppression apparatus for use in exposure apparatuses will be exemplified in the following embodiments.

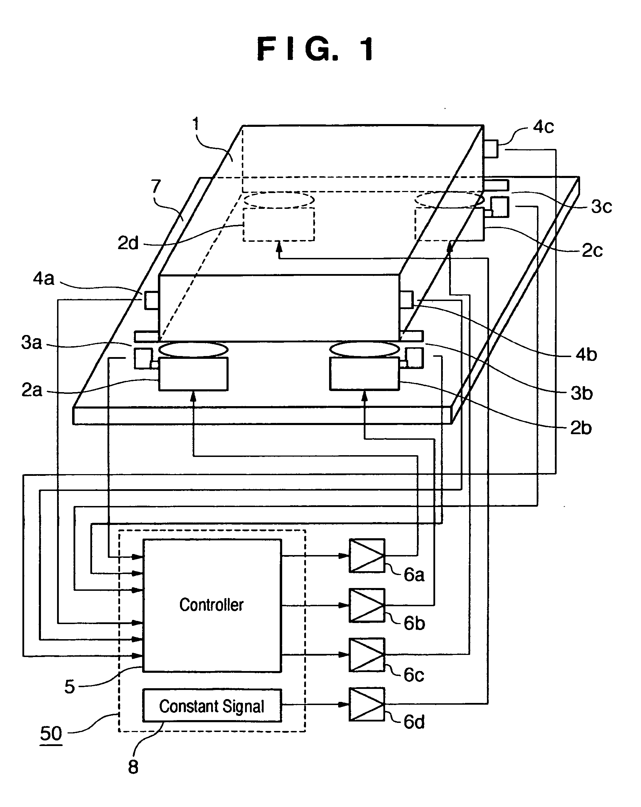

A first reference example of the present invention will be explained below referring to the drawings. A vibration suppression apparatus includes support mechanisms 2 having a vibration suppression function (to be simply referred to as support mechanisms hereinafter). The support mechanisms 2 support a surface plate 1 serving as a structure which mounts devices vulnerable to vibration in the main body of an exposure apparatus, such as an illumination system, a projection optical system, various types of measuring devices, and a substrate stage (wafer stage), while suppressing vibration of the structure. Fig. 1 does not show the illumination system, projection optical system, various types of measuring devices, substrate stage, and the like which are mounted on the surface plate 1.

The support mechanism 2 includes, for example, a spring element and damper element. In a technical field which requires precise vibration suppression, an air spring is widely used for the support mechanism 2. Especially in the field of active vibration suppression, the following arrangement is often adopted. That is, the arrangement forms an air pressure actuator by connecting a control valve such as a servo valve, which controls the internal pressure of a gas chamber (air chamber) storing air, to an air spring, and controls the position and vibration of a structure to support, using the actuator. In this case, an air pressure actuator can often be easily designed to have a spring rigidity by connecting a tank with an appropriate capacity to an air spring, and therefore often functions as the spring element of the support mechanism 2 as well. Note that the gas for use in the actuator is not particularly limited to air, and the air spring and air pressure actuator used herein are more generally interpreted as a gas spring and gas pressure actuator. A case in which air is used as an example of the gas will be explained hereinafter.

The support mechanism 2 according to this reference example includes an air pressure actuator 20. Each of support mechanisms 2a to 2d includes an air pressure actuator. As a matter of course, an air pressure actuator using, for example, an air cylinder can be used in place of an air spring. Alternatively, a spring mechanism having no function as an actuator and an air pressure actuator, electromagnetic actuator, or the like may be used together.

Four support mechanisms 2a to 2d which constitute actuators 20 are assumed to be provided herein, as shown in Fig. 1. Needless to say, the present invention incorporates an apparatus including five or more support mechanisms 2 in accordance with its design limitations.

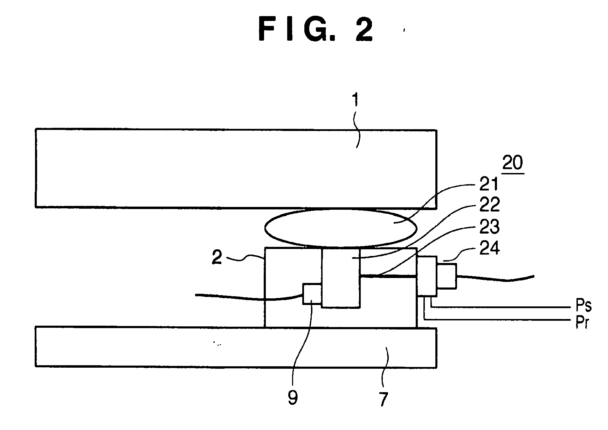

The support mechanism 2 can be preferably the one as shown in Fig. 2. Fig. 2 shows details of the internal arrangement.of the support mechanism 2. The support mechanism 2 includes the air pressure actuator 20. The air pressure actuator 20 includes an air spring 21, an air tank 22 connected to it, a control valve 24 which controls air supply/exhaust to/from the air spring 21 and air tank 22 which constitute an air chamber, and an air pipe 23. The air pipe 23 connects the air spring 21 and air tank 22 to the control valve 24. The control valve 24 is connected to a supply system Ps, which supplies compressed air, and an exhaust system Pr. The control valve 24 controls the internal pressures of the air spring 21 and air tank 22 by adjusting air supply/exhaust to/from them based on electrical command signals.

The air spring 21 also functions as a spring mechanism which constitutes the support mechanism 2. The spring rigidity of the air spring 21 is determined by, for example, the pressure-receiving area of the air spring 21, and the capacities and internal pressures of the air spring 21 and air tank 22. These design values are determined in accordance with a required specification.

The apparatus shown in Fig. 2 includes a pressure detector 9 which measures the internal pressures of the air spring 21 and air tank 22. This arrangement can be employed in the reference examples and embodiments to be described later as well, and is effective to improve the control precision and response characteristics of a control force produced by the air pressure actuator.

For the sake of descriptive convenience, the air pressure actuator 20 is assumed to act in the vertical direction in this reference example. As a matter of course, the same effect as described hereinafter can be produced even by using an air pressure actuator 20 which acts in the horizontal direction.

The plurality of support mechanisms 2 and actuators 20 are mounted and fixed on a base 7 such that three sets of them do not align themselves on the same straight line.

Conventionally, a reticle stage which mounts a reticle serving as a circuit original and moves, and a substrate stage which mounts and precisely aligns a substrate (wafer) in an exposure apparatus are mounted on a vibration suppression apparatus. The vibration suppression apparatus disclosed in the present invention may mount these stages as well. However, along with the recent increases in the performance of stages, the stages are often directly mounted on the base 7 without using the support mechanisms 2.

The vibration suppression apparatus according to this embodiment also includes a plurality of position detectors 3a to 3c which detect a displacement of the surface plate 1 with respect to a reference position, a plurality of vibration sensors 4a to 4c which detect vibration such as acceleration, and a compensation calculator 5 which performs compensation calculation for these detection signals.

The plurality of position detectors 3a to 3c are arranged such that their detection axes do not match each other. Likewise, the plurality of vibration sensors 4a to 4c are arranged such that their detection axes do not match each other.

The compensation calculator 5 is provided in a controller 50 and performs appropriate compensation calculation for a difference signal between the target position signal and position detection signal of the surface plate 1, or its vibration detection signal. The compensation signals output from the compensation calculator 5 are sent to driving circuits 6a to 6c to drive the actuators 20 of the support mechanisms 2a to 2c in accordance with this signal.

First actuators driven in accordance with the compensation signals output from the compensation calculator 5 are only actuators 20 of the three support mechanisms 2a to 2c. A second actuator 20 of the support mechanism 2d is not driven in accordance with any signals obtained by the compensation calculator 5.

The controller 50 includes a signal generator 8 which generates a constant signal representing a constant value. The signal provided by the signal generator 8 is sent to the second actuator 20 of the support mechanism 2d via a driving circuit 6d. The constant value can be set to the value of the signal input to the second actuator 20 of the support mechanism 2d when an apparatus (for example, an exposure apparatus) which mounts a control device is provided and aligns the surface plate 1 to a desired state.

The operation of the vibration suppression apparatus according to this reference example will be explained next. First, the position detectors 3a to 3c detect the position of the surface plate 1 with respect to a reference position. In addition, the vibration sensors 4a to 4c detect vibration such as acceleration of the surface plate 1. These detection signals are sent to the compensation calculator 5.

The compensation calculator 5 performs appropriate compensation calculation for these detection signals. As for the position detection signal, in general, the difference (deviation) between the position detection signal and a target value signal associated with the position of the surface plate 1 is calculated, and compensation calculation is performed for the calculated difference. To align the position of the surface plate 1 with the target position free from any deviation, compensation calculation including integral compensation, such as PI compensation or PID compensation, is typically adopted.

As for the vibration detection signal, compensation calculation according to the detection characteristics of the vibration sensor 4, and the response characteristics of the actuators 20 of the three support mechanisms 2a to 2c which apply control forces to the surface plate 1 are performed. For example, if an accelerometer and air pressure actuators are applied to the vibration sensor 4 and air pressure actuators 20 of the three support mechanisms 2a to 2c, respectively, gain compensation, integral compensation, or compensation as a combination thereof can be preferably used. When the actuators 20 of the three support mechanisms 2a to 2c have response frequencies sufficiently lower than the natural frequency of a mechanism system including the support mechanisms 2 and surface plate 1, the characteristics of the actuators 20 of the three support mechanisms 2a to 2c can be approximated by integral systems. For this reason, if, for example, gain compensation is performed, it is possible to produce a control force proportional to the velocity of the surface plate 1, thus controlling its damping characteristics. If integration compensation is adopted, it is possible to produce a control force proportional to a displacement of the surface plate 1, thus adjusting its support rigidity.

The compensation calculator 5 desirably adopts the above-mentioned compensation calculation after coordinate-transforming the position or vibration detection signal into the translational and rotational modes of the surface plate 1. The compensation signals obtained for the respective motion modes undergo calculation for distributing thrusts formulated based on the geometrical arrangement of the actuators 20 of the three support mechanisms 2a to 2c, and the resultant signals are distributed to the actuators 20 of the three support mechanisms 2a to 2c.

The compensation signals output from the compensation calculator 5 are sent to the actuators 20 of the support mechanisms 2a to 2c via the driving circuits 6a to 6c to drive the actuators 20 of the three support mechanisms 2a to 2c.

With the above-mentioned arrangement, the position and vibration of the surface plate 1 are controlled using the actuators 20 of the three support mechanisms 2a to 2c.

The second actuator 20 of the support mechanism 2d, which is not used for the above-mentioned position and vibration control, is driven in accordance with a signal provided by the signal generator 8 which generates a constant signal. The signal generator 8 generates a signal representing a constant value in accordance with the operation conditions of the vibration suppression apparatus. This signal may be always generated or turned on/off in accordance with the operation conditions of the vibration suppression apparatus.

The signal output from the signal generator 8 is sent to the driving circuit 6d to drive the second actuator 20 of the support mechanism 2d. As a consequence, the control force of the second actuator 20 of the support mechanism 2d is maintained as a constant force according to the signal output from the signal generator 8.

The rigid-body motion of the structure is based on a kinetic system defined by six degrees of freedom of motion, that is, three translational degrees of freedom and three rotational degrees of freedom. For example, the air pressure actuator 20 which acts in the vertical direction has degrees of freedom of motion defined by translation Z in the vertical direction and rotations θx and θy about the respective axes of translations X and Y in the horizontal direction perpendicular to the translation Z. In other words, because the air pressure actuator 20 has three degrees of freedom of motion, three air pressure actuators 20 can theoretically control the position and vibration of the rigid body. If three air pressure actuators 20 are adopted, there is only one combination of forces that achieves support balance of the motions Z, θx, and θy.

However, if there are four or more actuators 20, there are an infinite number of combinations of the control forces of the air pressure actuators 20 for maintaining an orientation defined by the same motions Z, θx, and θy. This is because the air pressure actuators 20 are redundant.

Even in this case, as long as a force produced by the actuator 20 of the support mechanism 2d other than three actuators of the three support mechanisms 2a to 2c is maintained constant, as in the vibration suppression apparatus disclosed in the present invention, there is only one combination of the control forces of the actuators for maintaining an orientation defined by the motions Z, θx, and θy. In other words, it is possible to keep the support balance of the surface plate 1 constant.

With the above-mentioned arrangement of the vibration suppression apparatus, one steady combination of forces that achieves support balance of the actuators 20 is obtained. Unless the load or its center of gravity changes, there is only one combination of forces that achieves support balance of the structure. For this reason, the support balance of the structure theoretically does not fluctuate. When a force produced by the second actuator 20 of the support mechanism 2d which maintains the produced force constant is set appropriately, it is possible to suppress deformation of the structure to support.

Although control of the position and vibration of the structure has been explained assuming that the number of actuators is four, the same applies to a case in which five or more air pressure actuators 20 are provided. In other words, it is only necessary that a minimum number of actuators required to control the rigid-body motion, that is, three actuators for the vertical direction and three actuators for the horizontal direction control the position and vibration of the structure, and actuators other than them produce constant forces.

Also, control of the position and vibration of the surface plate 1 is not particularly limited to that described herein. For example, Japanese Patent Laid-Open No. 11-294520 exemplifies a case in which the position control is performed by the same air pressure actuator as in this reference example, and the vibration control based on an acceleration signal is performed by an electromagnetic linear motor arranged parallel to it. Needless to say, even a vibration suppression apparatus having such a control system is expected to produce the same effect by operating actuators other than three actuators to produce constant control forces as in this embodiment. The present invention naturally incorporates such an arrangement.

A second reference example of the vibration suppression apparatus according to the present invention will be explained next. The second reference example is different from the first reference example in a method of controlling an actuator which produces a constant force.

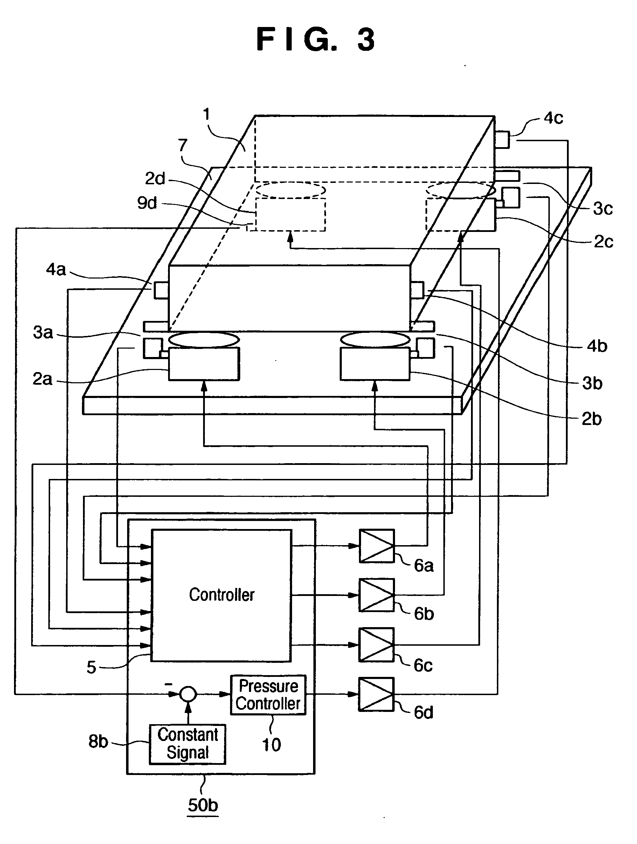

Fig. 3 is a view showing an arrangement according to the second reference example. A vibration suppression apparatus according to the second reference example shown in Fig. 3 includes a pressure detector 9d in a second actuator 20 of a support mechanism 2d, and controls a force produced by the second actuator 20 of the support mechanism 2d, using the detection signal from the pressure detector 9d. The pressure detector 9d detects the internal pressures of an air spring and air tank of the second air pressure actuator 20 of the support mechanism 2d in real time.

Also the vibration suppression apparatus in this reference example is different from that in the first reference example in a method of generating a control command signal issued to the second actuator 20 of the support mechanism 2d which produces a constant force. Their detailed difference lies in that a pressure compensation calculator 10 which performs compensation calculation for a difference signal between the signal from a signal generator 8b which generates a constant signal and the detection signal from the pressure detector 9d is provided, and a driving circuit 6d receives the output from the pressure compensation calculator 10. That is, in this reference example a controller 50b controls a control valve of the second actuator 20 of the support mechanism 2d based on the difference between a reference pressure and the output from the pressure detector 9d.

The signal generator 8b plays a role of generating target values set for the internal pressures of the air spring and air tank of the second air pressure actuator 20 of the support mechanism 2d. To control the internal pressures of the air spring and air tank of the second actuator 20 of the support mechanism 2d to follow the target values set by the signal generator 8b free from any deviations, the pressure compensation calculator 10 can preferably use a compensation calculation mechanism which exploits compensation calculation including integral compensation, such as PI compensation or PID compensation.

The controller in this reference example is different from that in the first reference example in the above-mentioned points, so it is denoted by reference numeral 50b in Fig. 3, differently from the controller 50 in Fig. 1. The compensation signal output from the pressure compensation calculator 10 is sent to the driving circuit 6d to drive the second actuator 20 of the support mechanism 2d.

With the above-mentioned arrangement, the same effect as in the first reference example can be produced by maintaining a force produced by the second actuator 20 of the support mechanism 2d constant. Moreover, the vibration suppression apparatus disclosed in this embodiment is configured to detect by the pressure detector 9d a force produced by the second actuator 20 of the support mechanism 2d, and to feed back the detection signal. Hence, the vibration suppression apparatus according to this embodiment additionally has a merit of maintaining a force produced by the second actuator 20 of the support mechanism 2d constant even when any disturbance such as a fluctuation in the supply air pressure of the second actuator 20 of the support mechanism 2d occurs.

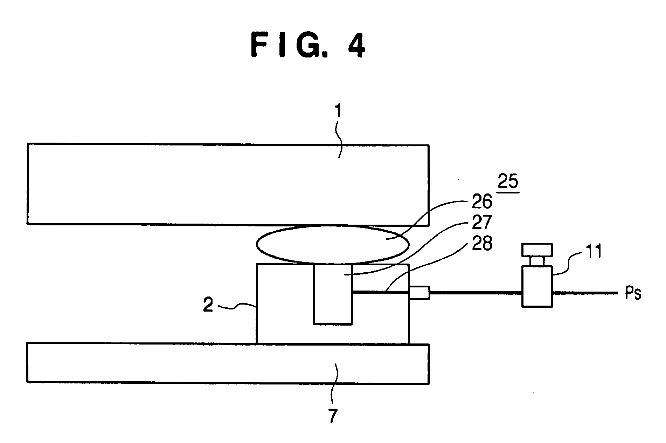

A third reference example of the present invention will be explained next. A vibration suppression apparatus disclosed in this reference example is different from those in the above-mentioned reference examples in the arrangement of an actuator for maintaining a produced force constant. Fig. 4 shows the arrangement of a second actuator 25 disclosed in this reference example.

The second actuator 25 includes the same elements, that is, an air spring 26, air tank 27, and air pipe 28, as in the second actuator 20 of the support mechanism 2d, but does not include a control valve 24. The second actuator 25 includes a precision air pressure regulator 11 as a mechanism which adjusts and sets the internal pressures of the air spring 26 and air tank 27.

The precision air pressure regulator 11 is also called a precision pressure reducing valve and inserted between an air pressure source and the second actuator 25. The precision air pressure regulator 11 functions to adjust the internal pressures of the air spring 26 and air tank 27 of the second actuator 25 to constant pressures set in advance. The precision air pressure regulator 11 is also simply called a pressure reducing valve, pressure reducing regulator, or pressure (air pressure) regulator. The precision air pressure regulator 11 used herein may be the one which can adjust its set pressure in accordance with an electrical command or the one the set pressure of which is adjusted by manual operation. The purpose of use of the precision air pressure regulator 11 is to maintain the internal pressures of the air spring 26 and air tank 27 constant, so even a precision air pressure regulator 11 of a manual type suffices.

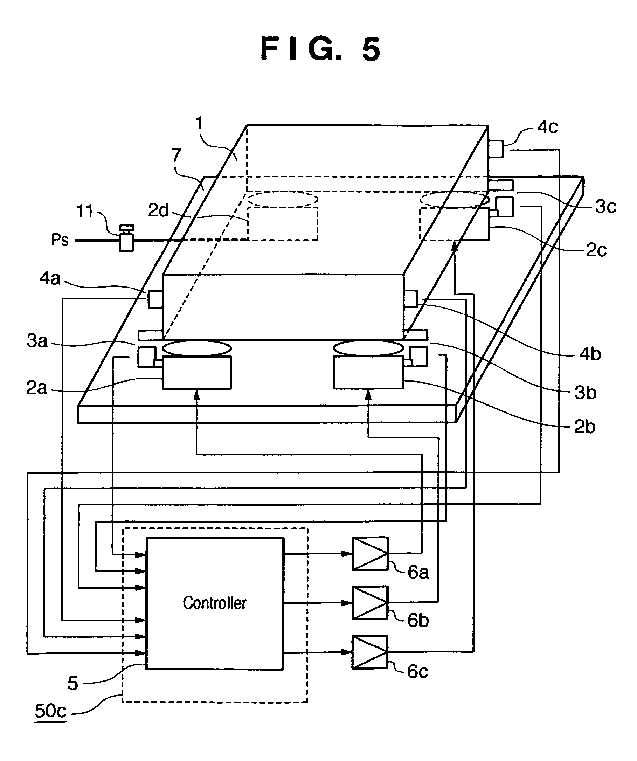

Fig. 5 is a view showing the schematic arrangement of an apparatus disclosed in this embodiment. This reference example is different from the first and second reference examples in that a support mechanism 2d includes the second actuator 25 in place of the second actuator 20 of the support mechanism 2d, and the internal pressure of the second actuator 25 is adjusted by the precision air pressure regulator 11 connected to it.

Fig. 5 assumes an apparatus including a precision air pressure regulator 11 of a manual type. On this assumption, an electrical mechanism for adjusting the internal pressure of the second actuator 25 is unnecessary, that is, a pressure detector 9, a driving circuit 6d, and a signal generator 8 or 8b for generating a constant signal are unnecessary. A controller 50c in this reference example includes only a compensation calculator 5 necessary for a control operation using first actuators 20 of three support mechanisms 2a to 2c other than the support mechanism 2d.

With the above-mentioned arrangement, the same effect as in the first and second reference examples can be produced by maintaining a force produced by the second actuator 25. Moreover, the vibration suppression apparatus disclosed in this reference example requires no electrical mechanism for adjusting the internal pressure of the second actuator 25. This makes it possible to further simplify the apparatus arrangement.

A first embodiment of the present invention will be explained next. The first to third examples have been explained assuming that there are four support mechanisms 2.

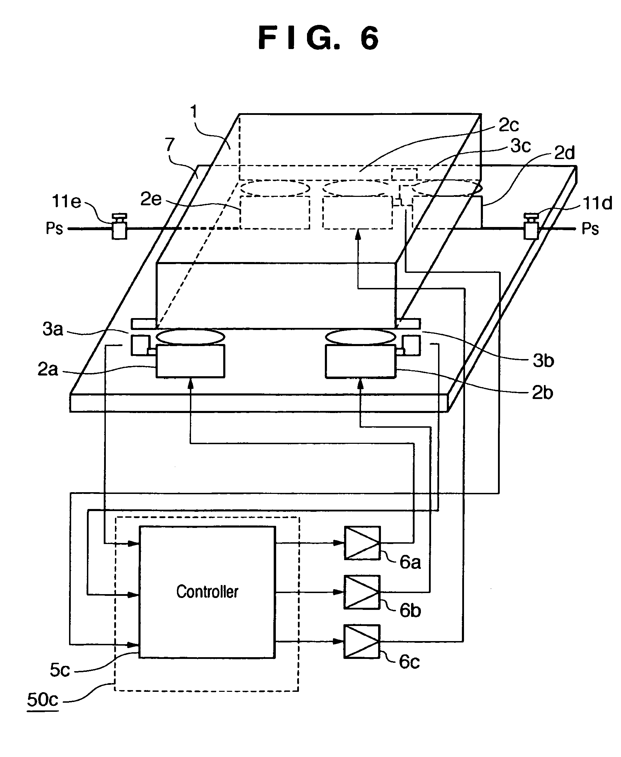

Fig. 6 is a view showing an example in which the vibration suppression apparatus according to the third reference example is improved to an apparatus including five support mechanisms 2. A vibration suppression apparatus according to the first embodiment includes five support mechanisms 2a to 2e, and operates second actuators of the support mechanisms 2d and 2e to produce constant control forces. The apparatus shown in Fig. 6 uses the precision air pressure regulator, which is disclosed in the third embodiment, as a mechanism which maintains forces produced by the second actuators of the support mechanisms 2d and 2e constant.

The apparatus in this embodiment is different from that in the third reference example shown in Fig. 5 in that a support mechanism 2e of a second actuator which produces a constant force is added. Other arrangements and operations of the apparatus in this embodiment are the same as in the apparatus shown in Fig. 5.

In this manner, even a vibration suppression apparatus including a larger number of actuators can produce the same effect as in the vibration suppression apparatuses according to the first to third reference examples.

Fig. 6 shows an arrangement in which a vibration sensor 4 and a control system based on the detection signal from it are omitted. As long as the vibration suppression apparatus can ensure damping characteristics good enough to stably operate, a vibration sensor 4 and a control system based on the detection signal from it may be omitted, as shown in Fig. 6.

### [Exposure Apparatus]

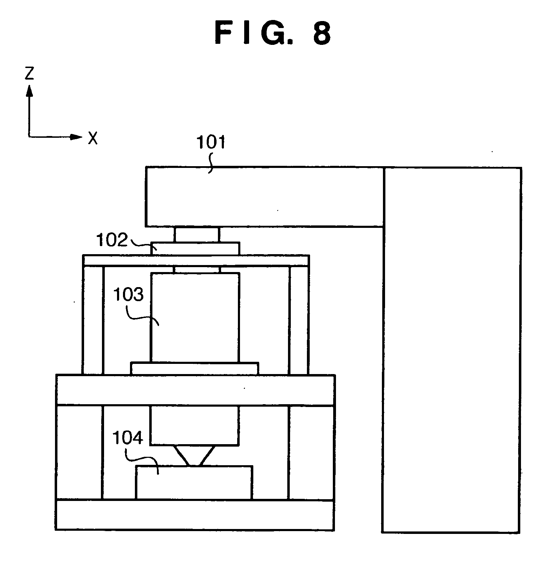

An exemplary exposure apparatus to which the vibration suppression apparatus according to the present invention is applied will be explained below. The exposure apparatus includes exposure units such as an illumination system 101, a reticle stage 102 which mounts a reticle, a projection optical system 103, and a wafer stage 104 which mounts a wafer, as shown in Fig. 8. The exposure apparatus also includes a surface plate which supports the exposure units, and the vibration suppression apparatus shown in any of the first to third reference examples and first embodiment, which supports the surface plate while suppressing its vibration. The exposure apparatus projects and transfers a circuit pattern formed on a reticle onto a wafer by exposure, and may be of the step & repeat projection exposure scheme or the step & scan projection exposure scheme.

The illumination system 101 illuminates a reticle on which a circuit pattern is formed, and includes a light source unit and illumination optical system. The light source unit uses, for example, a laser as the light source. The laser can be, for example, an ArF excimer laser having a wavelength of about 193 nm, a KrF excimer laser having a wavelength of about 248 nm, or an F₂ excimer laser having a wavelength of about 153 nm. However, the type of laser is not particularly limited to an excimer laser and may be, for example, a YAG laser, and the number of lasers is also not particularly limited. When a laser is used as the light source, an optical system for shaping a collimated light beam from the laser beam source into a desired beam shape, and an optical system for converting a coherent laser beam into an incoherent laser beam are preferably used. Also, the light source which can be used for the light source unit is not particularly limited to a laser, and one or a plurality of mercury lamps or xenon lamps can be used.

The illumination optical system illuminates a mask and includes, for example, a lens, mirror, light integrator, and stop.

The projection optical system 103 can be, for example, an optical system including a plurality of lens elements alone, an optical system including a plurality of lens elements and at least one concave mirror, an optical system including a plurality of lens elements and at least one diffractive optical element, or an optical system including only mirrors.

The reticle stage 102 and wafer stage 104 can move by, for example, a linear motor. In the step & scan projection exposure scheme, the stages 102 and 104 move synchronously. An actuator is separately provided to at least one of the wafer stage 104 and the reticle stage 102 to align the reticle pattern onto the wafer.

The above-described exposure apparatus can be used to manufacture micropatterned devices, for example, a semiconductor device such as a semiconductor integrated circuit, a micromachine, and a thin-film magnetic head.

### [Method of Manufacturing Device]

A reference example of a method of manufacturing a device using the above-mentioned exposure apparatus will be explained next. Devices (for example, a semiconductor integrated circuit device and liquid crystal display device) are manufactured by a step of exposing a substrate (for example, a wafer or glass plate) coated with a photosensitive agent, using the exposure apparatus according to any of the above-mentioned embodiments, a step of developing the substrate exposed in the exposing step, and other known steps (for example, etching, resist removing, dicing, bonding, and packaging steps).

## Claims

1. A vibration suppression apparatus, **characterized by** comprising:
three first actuators (2a-2c) and at least two second actuators (2d, 2e) configured to support a structure (1) by applying forces to the structure in a vertical direction and which do not all align themselves on an identical straight line;
a detector (3a-3c, 4a-4c) configured to detect at least one of vibration and a position of the structure (1) with respect to a reference position; and
a controller (5c) controlling the forces, applied to the structure (1) by the three first actuators (2a-2c), based on the output from the detector (3a-3c, 4a-4c),
wherein the second actuators (2d, 2e) are controlled so that a force applied to the structure (1) by the second actuators is maintained constant.

2. A vibration suppression apparatus, **characterized by** comprising:
three first actuators (2a-2c) and at least two second actuators (20) configured to support a structure (1) by applying forces to the structure (1) in a horizontal direction and do not align themselves on an identical straight line;
a detector (3a-3c, 4a-4c) configured to detect at least one of vibration and a position of the structure (1) with respect to a reference
position; and
a controller (5c) controlling the forces, applied to the structure (1) by the three first actuators (2a-2c), based on the output from the detector (3a-3c, 4a-4c),
wherein the second actuators (2d, 2e) are controlled so that a force applied to the structure (1) by the second actuators is maintained constant.

3. The vibration suppression apparatus according to claim 1 or clam 2, **characterized in that** the controller controls the second actuators so that a force applied to the structure by the second actuators is maintained constant by providing a signal representing a constant value to the second actuators.

4. The vibration suppression apparatus according to claim 1 or claim 2, **characterized in that** the second actuators include a gas chamber and apply, to the structure, a force controlled by adjusting an internal pressure of the gas chamber,
the vibration suppression apparatus further comprises a pressure detector configured to detect the internal pressure of the gas chamber of the second actuators, and
the controller controls a control valve of the second actuators based on the output from the pressure detector.

5. The vibration suppression apparatus according to claim 1 or claim 2, **characterized in that** the second actuators include a gas chamber and a pressure reducing valve controlling an internal pressure of the gas chamber to a pressure set in advance.

6. An exposure apparatus **characterized by** comprising:
a vibration suppression apparatus defined in any one of claims 1 to 5;
a surface plate supported by the vibration suppression apparatus; and
an exposure unit configured to expose a substrate and is supported by the surface plate.

## Patentansprüche

1. Schwingungsunterdrückungsvorrichtung, **gekennzeichnet durch**:
drei erste Aktuatoren (2a-2c) und mindestens zwei zweite Aktuatoren (2d, 2e), konfiguriert zum Halten einer Struktur (1) **durch** Ausübung - auf die Struktur in einer vertikalen Richtung - von Kräften, welche sich nicht sämtlich auf eine identische Gerade ausrichten;
einen Detektor (3a-3c, 4a-4c), konfiguriert zum Nachweis mindestens einer Schwingung und/oder einer Position der Struktur (1) bezüglich einer Referenzposition; und
eine Steuerung (5c) zur Steuerung der auf die Struktur (1) von den drei ersten Aktuatoren (2a-2c) ausgeübten Kräfte, und zwar basierend auf dem Ausgangssignal des Detektors (3a-3c, 4a-4c),
wobei die zweiten Aktuatoren (2d, 2e) derart gesteuert werden, dass eine auf die Struktur (1) von den zweiten Aktuatoren ausgeübte Kraft konstant gehalten wird.

2. Schwingungsunterdrückungsvorrichtung,
**gekennzeichnet durch** als umfassend:
drei erste Aktuatoren (2a-2c) und mindestens zwei zweite Aktuatoren (20), konfiguriert zum Halten einer Struktur (1) **durch** Ausüben - auf die Struktur (1) in einer horizontalen Richtung - von Kräften, welche sich nicht auf eine identische Gerade ausrichten;
einen Detektor (3a-3c, 4a-4c), konfiguriert zum Nachweis einer Schwingung und/oder einer Position der Struktur (1) bezüglich einer
Referenzposition; und
eine Steuerung (5c) zur Steuerung der auf die Struktur (1) von den drei ersten Aktuatoren (2a-2c) ausgeübten Kräfte, und zwar basierend auf dem Ausgangssignal des Detektors (3a-3c, 4a-4c),
wobei die zweiten Aktuatoren (2d, 2e) derart gesteuert werden, dass eine auf die Struktur (1) von den zweiten Aktuatoren ausgeübte Kraft konstant gehalten wird.

3. Vorrichtung nach Anspruch 1 oder 2, **dadurch gekennzeichnet, dass** die Steuerung die zweiten Aktuatoren so steuert, dass eine auf die Struktur von den zweiten Aktuatoren ausgeübte Kraft **dadurch** konstant gehalten wird, dass ein einen konstanten Wert repräsentierendes Signal zu den zweiten Aktuatoren gegeben wird.

4. Vorrichtung nach Anspruch 1 oder 2, **dadurch gekennzeichnet, dass** die zweiten Aktuatoren eine Gaskammer beinhalten und auf die Struktur eine Kraft ausüben, die gesteuert wird durch Einstellen eines Innendrucks der Gaskammer,
wobei die Schwingungsunterdrückungsvorrichtung ferner umafsst:
einen Druckfühler, konfiguriert zum Ermitteln des Innendrucks der Gaskammer der zweiten Aktuatoren, und
die Steuerung ein Steuerventil der zweiten Aktuatoren auf der Grundlage des Ausgangssignals des Druckfühlers steuert.

5. Vorrichtung nach Anspruch 1 oder 2, **dadurch gekennzeichnet, dass** die zweiten Aktuatoren eine Gaskammer beinhalten, sowie ein Druckreduzierventil, welches einen Innendruck der Gaskammer auf einen vorab eingestellten Druck regelt.

6. Belichtungsvorrichtung, **gekennzeichnet durch** als umfassend:
eine Schwingungsunterdrückungsvorrichtung nach einem der Ansprüche 1 bis 5;
eine Oberflächenplatte, die von der Schwingungsunterdrückungsvorrichtung gelagert wird; und
eine von der Oberflächenplatte gehaltene Belichtungseinheit, konfiguriert zum Belichten eines Substrats.

## Revendications

1. Appareil de suppression de vibrations, **caractérisé en ce qu'**il comprend :
trois premiers actionneurs (2a à 2c) et au moins deux deuxièmes actionneurs (2d, 2e) configurés de façon à supporter une structure (1) par l'application de forces à la structure dans une direction verticale et qui ne s'alignent pas tous sur une ligne droite identique ;
un détecteur (3a à 3c, 4a à 4c) configuré de façon à détecter au moins l'une parmi une vibration et une position de la structure (1) par rapport à une position de référence ; et
un dispositif de commande (5c) commandant les forces, appliquées à la structure (1) par les trois premiers actionneurs (2a à 2c), en fonction de la sortie du détecteur (3a à 3c, 4a à 4c),
dans lequel les deuxièmes actionneurs (2d, 2e) sont commandés de telle sorte qu'une force appliquée à la structure (1) par les deuxièmes actionneurs soit maintenue constante.

2. Appareil de suppression de vibrations, **caractérisé en ce qu'**il comprend :
trois premiers actionneurs (2a à 2c) et au moins deux deuxièmes actionneurs (20) configurés de façon à supporter une structure (1) par l'application de forces à la structure (1) dans une direction verticale et qui ne s'alignent pas sur une ligne droite identique ;
un détecteur (3a à 3c, 4a à 4c) configuré de façon à détecter au moins l'une parmi une vibration et une position de la structure (1) par rapport à une position de référence ; et
un dispositif de commande (5c) commandant les forces, appliquées à la structure (1) par les trois premiers actionneurs (2a à 2c), en fonction de la sortie du détecteur (3a à 3c, 4a à 4c),
dans lequel les deuxièmes actionneurs (2d, 2e) sont commandés de telle sorte qu'une force appliquée à la structure (1) par les deuxièmes actionneurs soit maintenue constante.

3. Appareil de suppression de vibrations selon la revendication 1 ou la revendication 2, **caractérisé en ce que** le dispositif de commande commande les deuxièmes actionneurs de telle sorte qu'une force appliquée à la structure par les deuxièmes actionneurs soit maintenue constante par la délivrance d'un signal représentant une valeur constante aux deuxièmes actionneurs.

4. Appareil de suppression de vibrations selon la revendication 1 ou la revendication 2, **caractérisé en ce que** les deuxièmes actionneurs comprennent une chambre à gaz et appliquent, à la structure, une force commandée par le réglage d'une pression interne de la chambre à gaz,
l'appareil de suppression de vibrations comprenant de plus un détecteur de pression configuré de façon à détecter la pression interne de la chambre à gaz des deuxièmes actionneurs, et
le dispositif de commande commandant une vanne de commande des deuxièmes actionneurs en fonction de la sortie du détecteur de pression.

5. Appareil de suppression de vibrations selon la revendication 1 ou la revendication 2, **caractérisé en ce que** les deuxièmes actionneurs comprennent une chambre à gaz et une vanne de réduction de pression commandant une pression interne de la chambre à gaz à une pression établie à l'avance.

6. Appareil d'exposition, **caractérisé en ce qu'**il comprend :
un appareil de suppression de vibrations selon l'une quelconque des revendications 1 à 5 ;
une plaque de surface supportée par l'appareil de suppression de vibrations ; et
une unité d'exposition configurée de façon à exposer un substrat et qui est supportée par la plaque de surface.
